# EUROPEAN PATENT SPECIFICATION

(11) **EP 0 260 141 B1**
(45) Date of publication and mention of the grant of the patent: **03.08.1994**
(21) Application number: 87308019.6
(22) Date of filing: 10.09.1987
(51) Int. Cl.: G02F 1/133

(54) **Liquid crystal apparatus**
Flüssigkristalleinrichtung
Dispositif à cristal liquide

(30) Priority: 11.09.1986 JP 214859/86; 21.08.1987 JP 207577/87
(43) Date of publication of application: 16.03.1988
(73) Proprietor: KABUSHIKI KAISHA TOSHIBA, Kawasaki-shi, Kanagawa-ken 210 (JP)
(72) Inventor: Takeno, Shozo, 1-1 Shibaura 1-chome Minato-ku Tokyo (JP); Kakegawa, Masayuki, 1-1 Shibaura 1-chome Minato-ku Tokyo (JP); Adachi, Yoshimasa, 1-1 Shibaura 1-chome Minato-ku Tokyo (JP)
(74) Representative: Freed, Arthur Woolf

(56) References cited:
- EP-A- 0 149 458
- DE-A- 2 449 740
- DE-A- 2 810 054
- US-A- 4 586 789

## Description

The present invention relates to a liquid crystal apparatus used to display several kinds of characters, marks, images or the like, and more particularly to a highly reliable liquid crystal apparatus in which the lead electrodes in a liquid crystal device are surely connected to the lead electrodes of a drive circuit board with less resistance.

Recently, liquid crystal apparatus have been designed to be used for television display, graphic display and the like, and therefore, it has become popular to develop liquid crystal apparatus having a large capacity and a high density and to put it practically used. Such a kind of liquid crystal apparatus has drive circuit boards which are connected to a liquid crystal device.

In the conventional liquid crystal apparatus, in order to connect a liquid crystal device with a drive circuit board the following method is adopted. That is, an electrical conductive rubber connector is disposed between each lead electrode of the liquid crystal device and the associated lead of the drive circuit board, and both are retained, as necessary, from the outside by a retaining mechanism such as a spring member to electrically connect both lead electrodes.

The electrical conductive conductive rubber connector is formed of several conductive layers each of which is made of an insulating material such as silicone rubber or the like, containing electrical conductive powder such as carbon powder, metal powder or the like, and which are arrayed at predetermined pitches, each conductive layer being formed so as to have a thickness which is less than the width of a lead electrode and also less than a space between lead electrodes. This conductive layer is produced such that a silicone rubber in a normally liquid form containing electrical powder dispersed therein is disposed between magnets to collect the electrical conductive material around magnetic poles, and is hardened in this condition.

With the electrical conductive rubber connector, there has been raised such a problem that the electrical conductivity of the boundary between each adjacent conductive layer and insulator in the electrical conductive rubber connector gradually varies, resulting in difficulty in thinning the connector and in low accuracy, and therefore, it has been difficult to carry out the connection of several lead electrodes with a high density, thereby the connector has been disable to have reliability.

Further, in the above method, since a retaining mechanisms are generally required, and therefore, there has been raised a problem of difficulty in thinning and miniaturizing of the products.

In order to solve the above-mentioned problem, there has been studied a method of connecting lead electrodes, in which an anisotropic conductive layer made of organic resin containing electrical conductive particles having substantially equal particle sizes is disposed between the lead electrodes of a liquid crystal device and a drive circuit board, and is subjected to thermocompression bonding so that the simple substance of the electrical conductive particles between the lead electrodes of the liquid crystal device and the drive circuit board made in presscontact with each other to connect both lead electrodes with each other.

However, since the lead electrodes of a common electrode for a liquid crystal device and the lead electrode of the drive circuit board are formed to have a relatively wide width such as, for example, about 2 mm in the arrangement of the conventional liquid crystal apparatus. This is due to that the electrical resistance is reduced to surely transmit signals.

Accordingly, with the above method, no relieving places are there for organic resin in such a part that the wide lead electrodes of the common electrode and the associated lead electrodes of the circuit board are vertically arranged, and therefore, a large amount of organic resin exists while the thickness of the anisotropic electrical conductive layer is unaltered. Accordingly, the contactness of the electrical conductive particle comes to be inferior, resulting in a large contact resistance, and in the worst case, the electrical connection cannot be obtained, which raised another problem.

For example, in the case of an active matrix type liquid crystal apparatus in which electrical connection is made by the above-metioned method, an electrical resistance of about 0.2 to 0.5 Ω/lead exists between the lead electrodes of the liquid crystal device other than the lead electrode and the associated lead electrodes of the circuit board, while an electrical resistance of about 1.0 to 1.5 Ω/lead exists between the lead electrodes of the common electrode and the associated lead electrodes of the circuit board. Further, for the test of reliability, under the atmosphere in which, for example, the temperature is 80°C and the humidity is 95% when a liquid crystal apparatus is left for 10 to 100 hours, the former resistance is changed to about 20 Ω/lead, while the latter resistance is changed to about 200 Ω/lead.

Further, as the above time is made to be long, the former resistance is limited so that it is slightly increased while the latter resistance is abruptly increased to have a value in a range form several kΩ to several hundred kΩ, and in the worst case, an open circuit is effected.

One object of the present invention is to provide a liquid crystal apparatus in which electrical connection between a liquid crystal device and a drive circuit with the use of an anisotropic electrical conductive layer can be uniformly made.

Another object of the present invention is to provide a liquid crystal apparatus in which electrical connection between a liquid crystal device and a drive circuit board with the use of an anisotropic electrical conductive layer can be made with a relatively low electrical resistance.

Still another object of the present invention is to provide a highly reliable liquid crystal apparatus.

The present invention provides a liquid crystal apparatus, including; a liquid crystal device comprising a first and a second substrate, liquid crystal material confined between said first and second substrates, a common electrode formed on said first substrate, a plurality of pixel electrodes and a plurality of thin film transistors formed on said second substrate, a plurality of lead electrodes and an electrode structure formed on one of said substrates, said plurality of lead electrodes being electrically connected to said thin film transistors and said electrode structure being electrically connected to said common electrode; a circuit board provided with a plurality of lead electrodes, and an electrode structure being disposed substantially opposite said plurality of lead electrodes and said electrode structure of said liquid crystal device; an anisotropic conductive layer disposed between said electrode structure and said lead electrodes of said liquid crystal device and said electrode structure and said lead electrodes of said circuit board and made of organic resin containing electrically conductive particles of substantially equal size, said electrically conductive particles making direct contact with said electrode structure and said lead electrodes to electrically connect opposed electrode structures and lead electrodes with each other; characterised in that said electrode structure of said liquid crystal device and/or said circuit board consists of several electrode elements, and the pitch and width of said several electrode elements are respectively each within a range of ±30% of the average values of the pitch and width of said plurality of lead electrodes.
Fig. 1 is a schematic view illustrating a circuit in an active matrix type liquid crystal apparatus;
Fig. 2 is a schematic cross-sectional view illustrating an active matrix type liquid crystal apparatus;
Fig. 3 is a schematic plan view illustrating a liquid crystal apparatus in one embodiment of the present invention;
Fig. 4 is an enlarged schematic plan view illustrating an essential part of Fig. 3;
Figs. 5a and 5b are schematic cross-sectional views illustrating the liquid crystal apparatus shown in one embodiment of the present invention, Fig. 5a showing before thermocompression bonding and Fig. 5b showing after thermocompression bonding;
Figs. 6a and 6b are schematic cross-sectional views illustrating a conventional liquid crystal apparatus in which anisotropic conductive layers are used, Fig. 6a showing before thermocompression bonding and Fig. 6b showing after thermocompression bonding;
Figs. 7a and 7b are schematic cross-sectional views illustrating a liquid crystal apparatus in another embodiment of the present invention, Fig. 7a showing before thermocompression bonding and Fig. 7b showing after thermocompression bonding;
Fig. 8 is a schematic view illustrating a liquid crystal apparatus in further another embodiment of the present invention;
Fig. 9 is an enlarged plan view illustrating an essential part of a liquid crystal apparatus shown in Fig. 8;

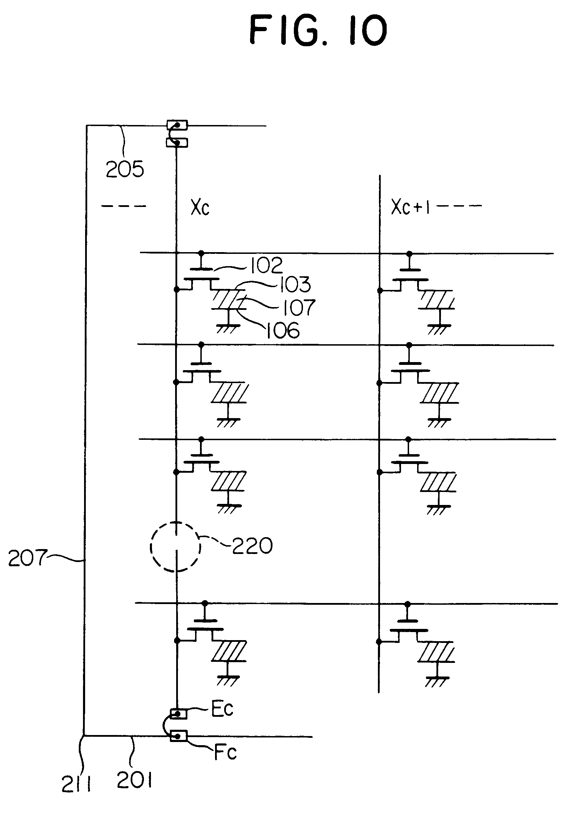

Fig. 10 is a schematic view illustrating a circuit in the liquid crystal apparatus of Fig. 8, for explaining a repairing condition thereof when a wire breakage occurs.

The embodiments of the present invention will be explained with reference to the drawings.

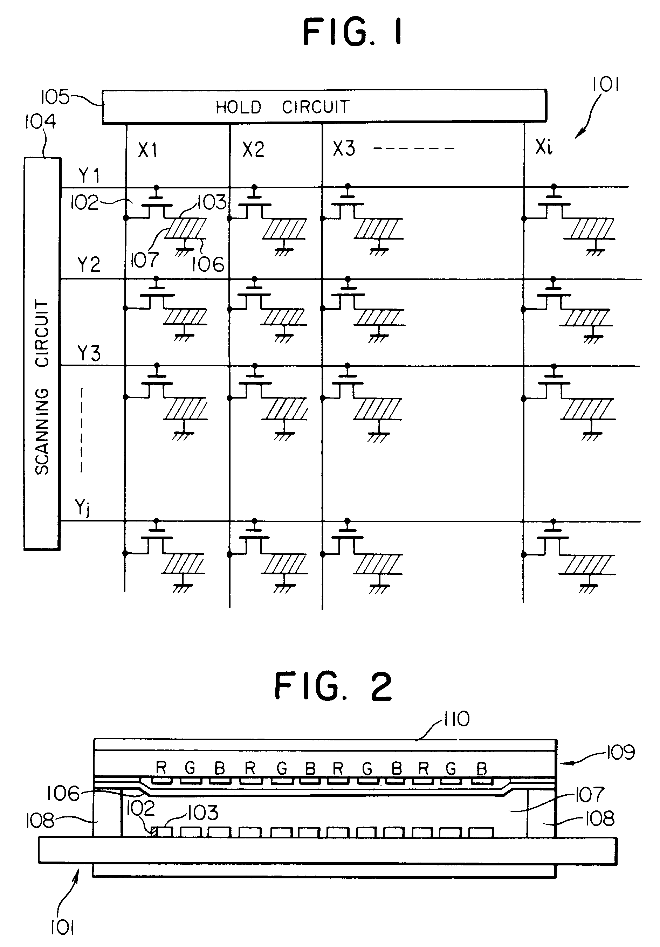

Fig. 1 shows a circuit diagram for an active matrix type liquid crystal apparatus. Several data lines Xᵢ (i = 1, 2, 3 ... n) and several gate lines Yⱼ (j = 1, 2, 3 ... n) substantially orthgonal to the former are formed in the array substrate 101. A TFT (thin film transistor) 102 is formed at each of the positions of crossing points between the data lines Xᵢ and the gate lines Yⱼ. Further, drain electrodes of the TFTs 102 are connected to the data lines for each column, and gate electrodes are connected to the gate lines Yⱼ for each row.

A transparent pixel electrode 103 is formed in each of matrix-like areas defined by the data lines X₁ and the gate lines Yⱼ, and is connected to a source electrode of each TFT 102.

The gate lines Yⱼ correspond to scanning lines and are connected to a scanning circuit 104. Further, the data lines Xᵢ are connected to a hold circuit 105 for feeding display signals in one horizontal line unit.

Further, a common electrode 106 is arranged opposing the transparent pixel electrodes 103, and liquid crystal 107 is sandwiched between the common electrode 106 and the transparent electrodes 103.

As shown in Fig. 2, the common electrode 106 is formed on a transparent substrate 109 which is opposed to the array substrate 101 and held by a spacer 108. Further, the transparent substrate 109 is also formed therein with filters for red (R), green (G) and blue (B) colors, corresponding to the transparent pixel electrodes 103, and a polarizing plate 110 is set on the outer surface of the transparent substrate 109 and the array substrate 101.

In the liquid crystal device having the above-mentioned arrangement, when a voltage is applied to, for example, the gate line (Y₁) while a high level data is fed to the data line X₁, the TFT 102 at the crossing point between the gate line Y₁ and the gate line X₁ is energized so that a voltage is accumulated between the transparent pixel electrode 103 at this position and the common electrode 106, resulting in the liquid crystal 107 being oriented, and therefore, light can pass through this part when the transmission axes of two polarizing plates 110 are about parallel each other. Thus, pixels through which light is transmitted are selected in accordance with signals from the data lines Xᵢ so that it is possible to display an image. The gate lines Yⱼ are scanned at a predetermined frequency, and therefore, accumulated voltage at pixel electrodes are rewritten at this frequency.

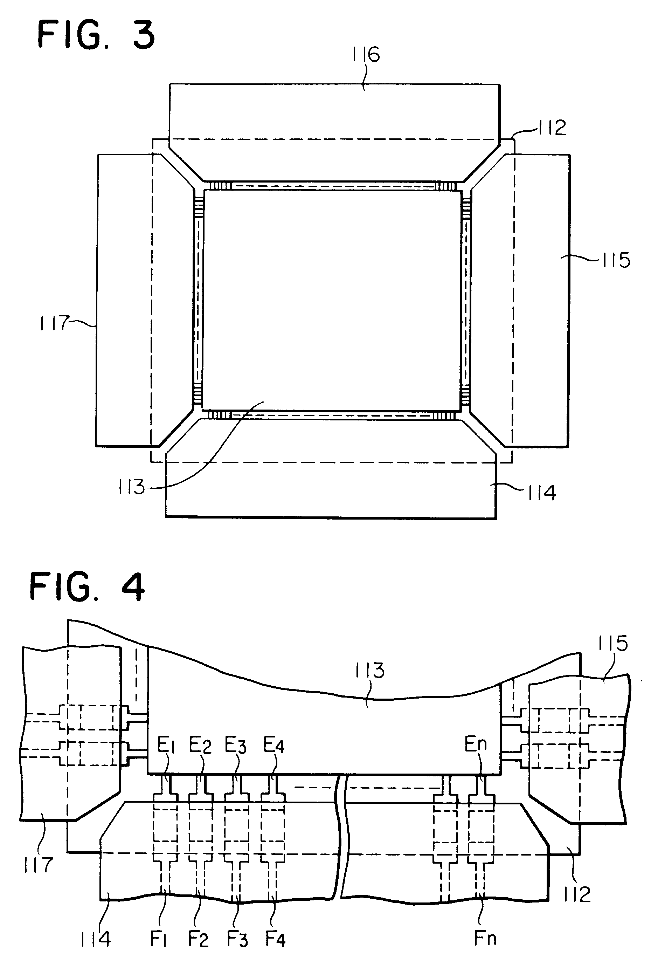

Fig. 3 shows the external view of the active matrix type liquid crystal apparatus. As explained above, the center area of a liquid crystal device 112 composed of the array substrate 101, transparent substrate 109, the liquid crystal 107 sandwiched therebetween and the like, serves as liquid crystal display section 113. Further, as shown in Fig. 4, lead electrodes for applying voltage to the transparent pixel electrodes 103, and lead electrodes Eᵢ (i = 1, 2, 3 ... n) of the common electrode 106 are provided along the four sides of one of the substrates, for example, the array substrate 101.

Further, the lead electrodes of the common electrode 106 are spaced so that they have pitches and width substantially identical to those of lead electrodes for the transparent pixel electrodes 103. In this arrangement, for example, the lead electrodes E₁ to E₇ are allocated for the lead electrodes of the common electrode 106, and the lead electrodes E₈ to Eₙ are allocated for the lead electrodes for the transparent pixel electrodes 103.

Further, circuit boards 114, 115, 116 and 117, each composed of a flexible printed circuit (FPC) mounted thereof with a driver IC chip (not shown), are arranged along the sides of the liquid crystal device 112, respectively, having lead electrodes Fⱼ (j = 1, 2, 3 ... n) corresponding to the lead electrodes.

The lead electrodes Fⱼ of these circuit board 114, 115, 116 and 117 are connected to the lead electrodes E₁ of the liquid crystal device 112, as explained hereinbelow.

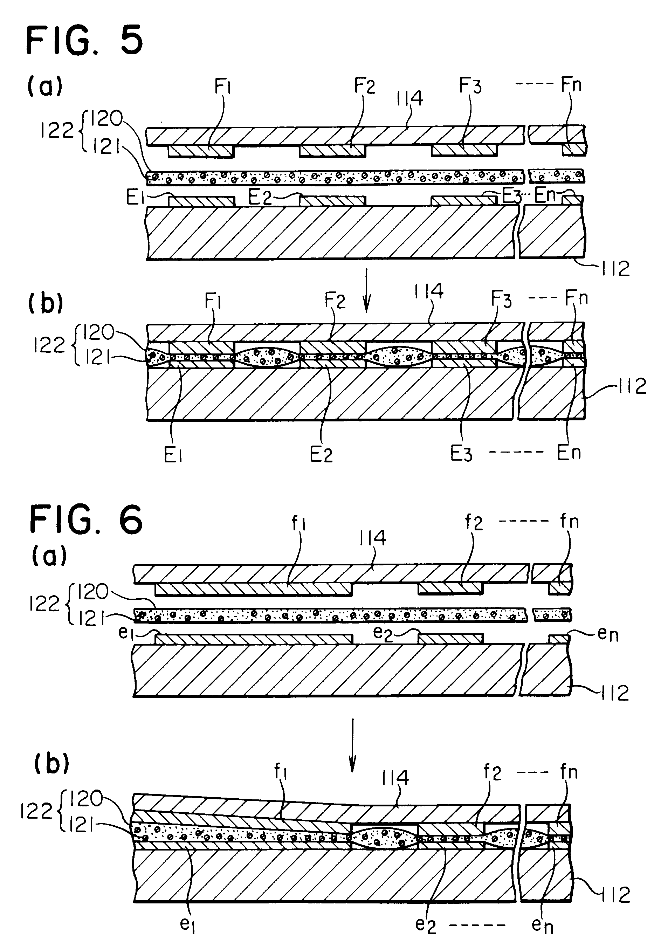

As shown in Fig. 5a, on the array substrate made of a glass substrate having a thickness of about 1.0 mm, aluminum lead electrodes having a width of 50 to 250 µm, for example, 165 µm and a thickness of about 1 µm are formed at pitches of 150 to 500 µm, for example, 330 µm. Further, on a film such as polyimide film or the like, having a thickness of about 25 µm, flexible tape lead electrodes Fⱼ made of Cu + Ni + Au, having a width of 165 µm, and a thickness of 10 to 500 µm, for example, 18 µm are formed at pitches of 330 µm. It is noted that the lead electrodes E₁ are allocated for the lead electrodes of the common electrode 106 and the lead electrodes of the transparent pixel electrodes 103 in the liquid crystal device 112, and therefore, have substantially identical pitches and widths.

Further, an anisotropic conductive layer 122 having a thickness of 10 to 30 µm, for example, 25 µm, and made of a thermoplastic resin binder 120 in which electrical conductive particles 121 such as Ni particles coated with a film made of Ni, alloy thereof or Au and having a particle size of 1 to 10 µm, for example, about 2 µm, are dispersed, is disposed between the lead electrodes Eᵢ, Fⱼ. It is noted that a film having a commercial name "Anisolm" available from Hitachi Chemical Industrial Co., or the like can be used as such an anisotropic conductive layer 122.

Then, they are heated and pressed under the condition of a temperature of 150°C and a pressure of 30 kg/cm² for 20 sec., and therefore, the anisotropic conductive layer 122 is dispressed so as to be connected, as shown in Fig. 5b.

With the liquid crystal apparatus in this embodiment having the above-mentioned arrangement, the interelectrode resistance was measured, it had a low value such as 0.2 to 0.5 Ω/lead over 240 leads, and an uniform result was obtained. Further, in this case the concentration of the electrical conductive particles per lead was such that about 10 to 20 particles were there.

Figs. 6a and 6b show a conventional liquid crystal apparatus using an anisotropic conductive layer 122.

In such a conventional liquid crystal device, the lead electrode e₁ of the common electrode and the associated lead electrode f₁ of the circuit board are formed to be wide. Accordingly, in such a part that the lead electrode e₁ and the lead electrode f₁ are arranged in the vertical direction, organic resin has no relieving place and therefore, the anisotropic conductive layer 122 has still a large thickness having a large amount of organic resin between the lead electrodes e₁, f₁ so that the contactness of the electrical conductive particles 121 is insufficient, resulting in incresing the contact resistance, and in the most worst case, no electrical connection cannot be obtained.

On the contrary, in the liquid crystal apparatus according to the present invention, the lead electrodes of the common electrodes in the liquid crystal device 112 and the lead electrodes of the circuit board corresponding to to the lead electrodes of the common electrode, are spaced. Accordingly, when the anisotropic conductive layer 122 is disposed between the lead electrodes and are subjected to thermocompression bonding, as shown in Fig. 5b, the anisotropic conductive layer 122 are depressed by the lead electrodes E₁, F₁ and therefore thinned while organic resin 120 is pushed out through the gaps between adjacent lead electrodes so that the electrical conductive particles 121 are held between the electrodes in the vertical direction to ensure electrical connection. Accordingly, since pressure is uniformly applied to the film during thermocompression bonding, and the relieving places for organic resin 120 can be formed, the thickness of the anisotropic conductive layer 122 are made uniform over the electrode section in its entirety, and therefore the contact resistance is made to be low and uniform.

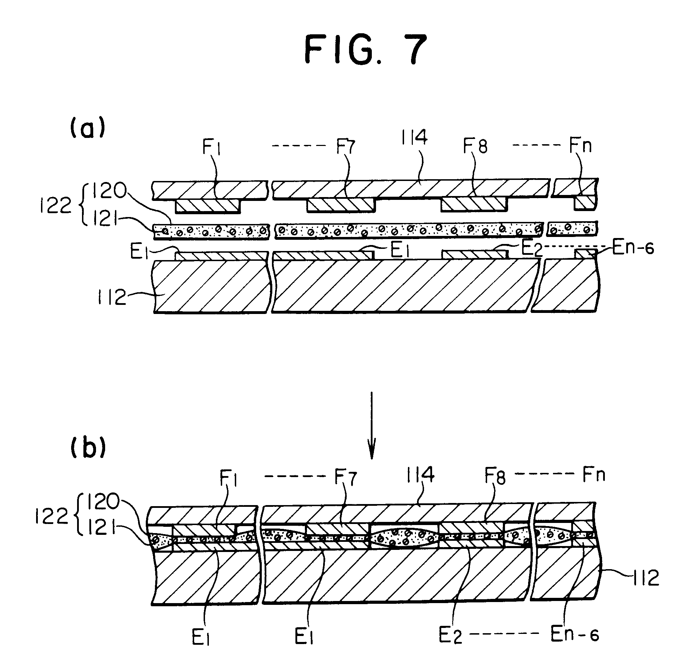

Figs. 7a and 7b show a liquid crystal apparatus in another embodiment, in which the identical reference numerals are given to those indentical to the parts of Figs. 5a and 5b.

In this embodiment, the lead electrode E₁ of the common electrode in the liquid crystal device 112 has a width of about 2 mm, and there are provided several separated electrodes, for example, seven electrodes F₁ to F₇ corresponding to the above-mentioned single electrode E₁, and having pitches and a width substantially equal to those of the lead electrodes Fₙ of the circuit board. Even in such a liquid crystal apparatus, it is possible to obtain technical effects and advantages similar to those obtained by the liquid crystal apparatus in the aforementioned embodiment.

It is noted that errors occur during the production of the liquid crystal apparatus even though the pitches and widths of the lead electrodes are made to be identical. Further, as it is understood from the above explanation, the way of spacing the lead electrodes of the common electrode and the lead electrodes corresponding the lead electrodes of the common electrodes is not always necessary to do such that they have the similar pitches and widths of the other lead electrodes. However, in order to satisfy uniformity, the lead electrodes preferably has pitches and widths ranges of ± 30% around their respective average values.

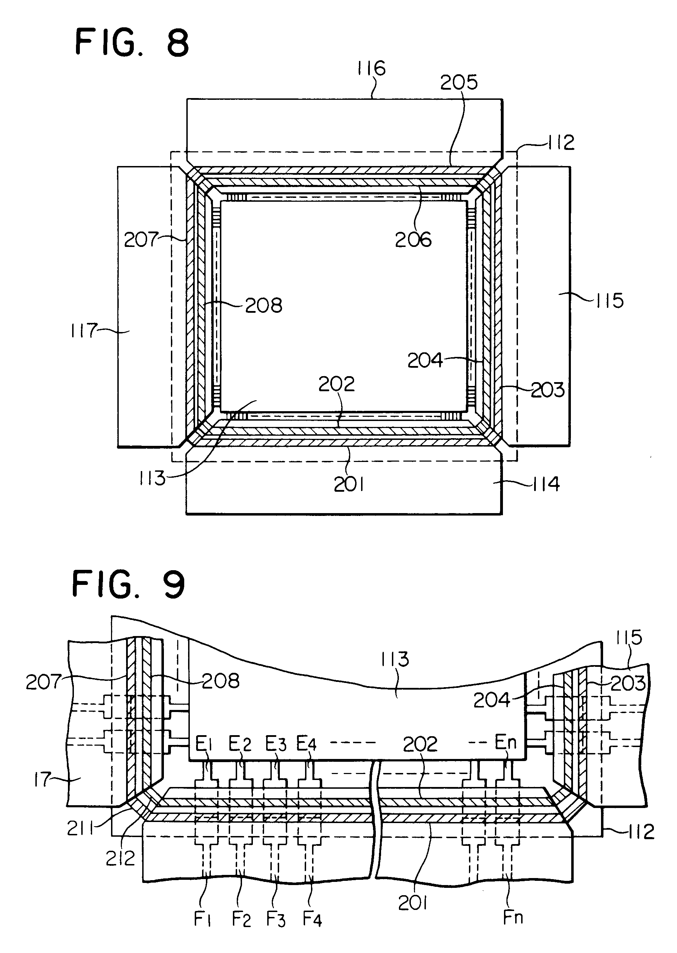

Figs. 8 and 9 show a liquid crystal device in further another embodiment of the present invention, in which indentical reference numerals are given to those indentical parts in the liquid crystal device of Figs. 3 and 4.

In this liquid crystal device, a series of pattern wirings 201 and 202 are formed on the rear side of the lead electrodes Fⱼ of the drive circuit 114, along the direction in which the lead electrodes Fⱼ are parallelly arranged. It is noted that the number of the pattern wirings is two in this case, but the number of the pattern wirings should not be limited to this number.

Further, pattern wirings 203 to 208 are formed similarly on the rear side of the lead electrodes of the drive circuit boards 115, 116 and 117.

Accordingly, the above-mentioned pattern wirings 210 to 208 serve to reinforce the output electrode sections of the flexible drive circuit boards 114 to 117 toward the lead electrode pitch direction. That is, even if the drive circuit boards 114 to 117 tend to expand and contract due to variations in temperature, humidity or the like, the tendency is restrained by the pattern wirings 201 to 208. As a result, in the case of that the output electrodes Fⱼ of the drive circuit boards 115, 116 and 117 are connected to the substrate electrodes E₁ of the array substrate 101, being opposed to each other, no pitch deviation occurs therebetween, and therefore, it is possible to ensure satisfactory and accurate connection.

Further, in order to connect pattern wirings on each adjacent circuit boards, connecting patterns 211 and 212 are previously formed on, for example, the array substrate 101 as shown in Fig. 9, and connection is made with the use of a soldering process. Accordingly, in the case of that a loop is formed by, for example, the pattern wirings 201, 203, 205 and 207, if any wire breakage occurs in, for example, a wire breakage part 220 of the data line X_{c}, the electrode F_{c} or E_{c} is connected to the pattern wiring 201, and the part is connected to the electrode on the side opposite to the data line X_{c} through the intermediary of this pattern wiring. Thus, even though the wire breakage part would be there, data can be indirectly fed to a part of devices by way of the pattern wiring, and therefore, the devices to be fed with data can be all operated in a normal way.

## Claims

1. A liquid crystal apparatus, including;
a liquid crystal device (112) comprising a first and a second substrate (109, 101), liquid crystal material (107) confined between said first and second substrates, a common electrode (106) formed on said first substrate, a plurality of pixel electrodes (103) and a plurality of thin film transistors (102) formed on said second substrate, a plurality of lead electrodes (E) and an electrode structure (E) formed on one of said substrates, said plurality of lead electrodes being electrically connected to said thin film transistors and said electrode structure being electrically connected to said common electrode;
a circuit board (114-117) provided with a plurality of lead electrodes (F), and an electrode structure (F) being disposed substantially opposite said plurality of lead electrodes and said electrode structure of said liquid crystal device;
an anisotropic conductive layer (122) disposed between said electrode structure and said lead electrodes (E) of said liquid crystal device (112) and said electrode structure and said lead electrodes (F) of said circuit board (114-117) and made of organic resin (120) containing electrically conductive particles (121) of substantially equal size, said electrically conductive particles (121) making direct contact with said electrode structure and said lead electrodes (E,F) to electrically connect opposed electrode structures and lead electrodes (E,F) with each other;
characterised in that said electrode structure of said liquid crystal device (112) and/or said circuit board (114-117) consists of several electrode elements (E₁-E₄;E₁-E₇;F₁-F₄;F₁-F₇), and the pitch
and width of said several electrode elements are respectively each within a range of ±30% of the average values of the pitch and width of said plurality of lead electrodes.

2. A liquid crystal apparatus according to claim 1, characterised in that the pitch and width of the lead electrodes of the liquid crystal device (112) and/or the circuit board (114-117) are respectively substantially even.

3. A liquid crystal apparatus according to claim 1 or 2, characterised in that said liquid crystal device (112) is an active matrix type liquid crystal device having semiconductor elements (102) on said pixel electrode (103).

## Patentansprüche

1. Flüssigkristalleinrichtung, die aufweist:
eine Flüssigkristallvorrichtung (112) mit einem ersten und einem zweiten Substrat (109, 101), mit zwischen dem ersten und dem zweiten Substrat eingeschlossenem Flüssigkristallmaterial (107), einer auf dem ersten Substrat ausgebildeten Masseelektrode (106), mehreren Pixelelektroden (103) und mehreren Dünnschichttransistoren (102), die auf dem zweiten Substrat ausgebildet sind, mehreren Anschlußelektroden (E) und einer Elektrodenstruktur (E), die auf einem der Substrate ausgebildet sind, wobei die mehreren Anschlußelektroden elektrisch mit den Dünnschichttransistoren verbunden sind und die Elektrodenstruktur elektrisch mit der Masseelektrode verbunden ist;
eine Leiterplatte (114-117) mit mehreren Anschlußelektroden (F) und einer Elektrodenstruktur (F), die im wesentlichen gegenüber den mehreren Anschlußelektroden und der Elektrodenstruktur der Flüssigkristallvorrichtung angeordnet sind;
eine anisotrope leitfähige Schicht (122), die zwischen der Elektrodenstruktur und den Anschlußelektroden (E) der Flüssigkristallvorrichtung (112) und der Elektrodenstruktur und den Anschlußelektroden (F) der Leiterplatte (114-117) angeordnet ist und aus einem Kunstharz (120) besteht, das elektrisch leitende Teilchen (121) von im wesentlichen gleicher Größe enthält, wobei die elektrisch leitenden Teilchen (121) in direkten Kontakt mit der Elektrodenstruktur und den Anschlußelektroden (E, F) kommen, um einander gegenüberliegende Elektrodenstrukturen und Anschlußelektroden (E, F) elektrisch miteinander zu verbinden;
dadurch gekennzeichnet, daß die Elektrodenstruktur der Flüssigkristallvorrichtung (112) und/oder der Leiterplatte (114-117) aus mehreren Elektrodenelementen (E₁-E₄; E₁-E₇; F₁-F₄; F₁-F₇) besteht und daß Abstand und Breite der mehreren Elektrodenelemente jeweils innerhalb eines Bereichs von ± 30% um die Mittelwerte des Abstands und der Breite der mehreren Anschlußelektroden liegen.

2. Flüssigkristalleinrichtung nach Anspruch 1, dadurch gekennzeichnet, daß der Abstand und die Breite der Anschlußelektroden der Flüssigkristallvorrichtung (112) und/oder der Leiterplatte (114-117) jeweils im wesentlichen gleichmäßig sind.

3. Flüssigkristalleinrichtung nach Anspruch 1 oder Anspruch 2, dadurch gekennzeichnet, daß die Flüssigkristallvorrichtung (112) eine Flüssigkristallvorrichtung mit aktiver Matrix ist, der auf der Pixelelektrode (103) Halbleiterelemente (102) aufweist.

## Revendications

1. Un appareil à cristaux liquides, englobant:
un dispositif à cristaux liquides (112) comprenant un premier et un deuxième substrat (109, 101), du matériau de cristal liquide (107) renfermé entre lesdits premier et deuxième substrats, une électrode commune (106) agencée sur ledit premier substrat, plusieurs électrodes à pixels (103) et plusieurs transistors à couche mince (102) agencés sur ledit deuxième substrat, plusieurs électrodes d'entrée (E) et une structure d'électrode (E) agencées sur l'un des dits substrats, lesdites plusieurs électrodes d'entrée étant connectées électriquement aux dits transistors à couche mince et ladite structure d'électrode étant connectée électriquement à ladite électrode commune;
une plaquette de circuit (114-117) comportant plusieurs électrodes d'entrée (F), une structure d'électrode (F) étant agencée en un point pratiquement opposé aux dites plusieurs électrodes d'entrée et à ladite structure d'électrode du dit dispositif à cristaux liquides;
une couche conductrice anisotrope (122) agencée entre ladite structure d'électrode et lesdites électrodes d'entrée (E) du dit dispositif à cristaux liquides (112) et ladite structure d'électrode et lesdites électrodes d'entrée (F) de ladite plaquette de circuit (114-117), composée de résine organique (120) contenant des particules électroconductrices (121) de grosseur pratiquement égale, lesdites particules électroconductrices (121) établissant un contact direct avec ladite structure d'électrode et lesdites électrodes d'entrée (E, F) en vue de la connexion électrique de structures d'électrode et des électrodes d'entrée opposées (E, F);
caractérisé en ce que ladite structure d'électrode du dit dispositif à cristaux liquides (112) et/ou ladite plaquette de circuit imprimé (114-117) se composent de plusieurs éléments d'électrode (E₁-E₄; E₁-E₇; F₁-F₄; F₁-F₇), la distance et la largeur des dits plusieurs éléments d'électrode correspondant respectivement chacune à une valeur de ± 30% des valeurs moyennes de la distance et de la largeur des dites plusieurs électrodes d'entrée.

2. Un appareil à cristaux liquides selon la revendication 1, caractérisé en ce que la distance et la largeur respectives des électrodes d'entrée du dispositif à cristaux liquides (112) et/ou de la plaquette de circuit (114-117) sont pratiquement identiques.

3. Un appareil à cristaux liquides selon les revendications 1 ou 2, caractérisé en ce que ledit dispositif à cristaux liquides (112) est un dispositif à cristaux liquides du type à matrice active comportant des éléments semiconducteurs (102) sur ladite électrode à pixels (103).
